# EUROPÄISCHE PATENTSCHRIFT

(11) **EP 3 074 821 B1**
(45) Veröffentlichungstag und Bekanntmachung des Hinweises auf die Patenterteilung: **28.10.2020**
(21) Anmeldenummer: 14814783.8
(22) Anmeldetag: 25.11.2014
(51) Int. Cl.: G03F 7/20, G01N 21/84, G01N 21/55, G02B 17/02, G01N 21/956, G02B 17/06, G02B 19/00

(54) **MESSANORDNUNG ZUR MESSUNG OPTISCHER EIGENSCHAFTEN EINES REFLEKTIVEN OPTISCHEN ELEMENTS, INSBESONDERE FÜR DIE MIKROLITHOGRAPHIE**
MEASURING ARRANGEMENT FOR MEASURING OPTICAL PROPERTIES OF A REFLECTIVE OPTICAL ELEMENT, IN PARTICULAR FOR MICROLITHOGRAPHY
ARRANGEMENT DE MESURE POUR LA MESURE DES PROPRIÉTÉS OPTIQUES D'UN ÉLÉMENT OPTIQUE RÉFLÉCHISSANT, NOTAMMENT POUR LA MICROLITHOGRAPHIE

(30) Priorität: 28.11.2013 DE 102013224435
(43) Veröffentlichungstag der Anmeldung: 05.10.2016
(73) Patentinhaber: Carl Zeiss SMT GmbH, 73447 Oberkochen (DE)
(72) Erfinder: BOL, Johannes, 73447 Oberkochen (DE); ROSTALSKI, Hans-Jürgen, 73447 Oberkochen (DE)
(74) Vertreter: Frank, Hartmut
(86) Internationale Anmeldenummer: PCT/EP2014/075537
(87) Internationale Veröffentlichungsnummer: WO 2015/078861

(56) Entgegenhaltungen:
- EP-A1- 1 249 698
- DE-A1-102007 051 671
- US-B2- 7 016 030

## Beschreibung

### HINTERGRUND DER ERFINDUNG

### Gebiet der Erfindung

Die Erfindung betrifft eine Messanordnung zur Messung optischer Eigenschaften eines reflektiven optischen Elements, insbesondere für die Mikrolithographie.

### Stand der Technik

Mikrolithographie wird zur Herstellung mikrostrukturierter Bauelemente, wie beispielsweise integrierter Schaltkreise oder LCD's, angewendet. Der Mikrolithographieprozess wird in einer sogenannten Projektionsbelichtungsanlage durchgeführt, welche eine Beleuchtungseinrichtung und ein Projektionsobjektiv aufweist. Das Bild einer mittels der Beleuchtungseinrichtung beleuchteten Maske (= Retikel) wird hierbei mittels des Projektionsobjektivs auf ein mit einer lichtempfindlichen Schicht (Photoresist) beschichtetes und in der Bildebene des Projektionsobjektivs angeordnetes Substrat (z.B. ein Siliziumwafer) projiziert, um die Maskenstruktur auf die lichtempfindliche Beschichtung des Substrats zu übertragen.

In für den EUV-Bereich ausgelegten Projektionsobjektiven, d.h. bei Wellenlängen von z.B. etwa 13 nm oder etwa 7 nm, werden mangels Verfügbarkeit geeigneter lichtdurchlässiger refraktiver Materialien Spiegel als optische Komponenten für den Abbildungsprozess verwendet. Solche EUV-Spiegel weisen typischerweise ein Spiegelsubstrat und einen aus einer Vielzahl von Schichtpaketen aufgebauten Reflexionsschichtstapel zur Reflexion der auf die optische Wirkfläche auftreffenden elektromagnetischen Strahlung auf. In der Beleuchtungseinrichtung einer für den Betrieb im EUV ausgelegten mikrolithographischen Projektionsbelichtungsanlage ist insbesondere der Einsatz von Facettenspiegeln in Form von Feldfacettenspiegeln und Pupillenfacettenspiegeln als bündelführende Komponenten z.B. aus DE 10 2008 009 600 A1 bekannt. Derartige Facettenspiegel sind aus einer Vielzahl von Einzelspiegeln oder Spiegelfacetten aufgebaut.

In der Praxis besteht häufig ein Bedarf, die Reflexionseigenschaften solcher Spiegel bzw. Spiegelanordnungen mit möglichst hoher Genauigkeit sowie - insbesondere bei Spiegelanordnungen aus vergleichsweise kleinen Spiegeln wie den vorstehend genannten Facettenspiegeln - mit hoher Ortsauflösung zu vermessen. Hierbei tritt jedoch das Problem auf, dass einer hierzu denkbaren, immer stärkeren Verkleinerung der jeweiligen Messspots insofern Grenzen gesetzt sind, als die Verkleinerung der Messspots mit einer Erhöhung der Strahldivergenz oder Verringerung der Intensität einhergeht, was wiederum dazu führt, dass ein relativ breites Spektrum unterschiedlicher Einfallswinkel erzielt wird, welches die letztlich bei der Messung erzielte spektrale Auflösung beeinträchtigt.

Zur ortsaufgelösten Messung der Reflexionseigenschaften eines reflektiven optischen Elements ist es weiter bekannt, im Fernfeld der zu untersuchenden, vollflächig beleuchteten reflektiven Fläche einen Detektor z.B. in Form einer CCD-Kamera anzuordnen. Hierbei tritt jedoch das weitere Problem auf, dass Rauigkeiten der zu untersuchenden reflektiven Fläche (wenn diese z.B. nicht gut poliert oder die Reflexionsbeschichtung ungleichmäßig dick ist) zu Deformationen der jeweils an dieser Fläche reflektierten Wellenfronten führen, was unerwünschte Interferenzeffekte am Detektor zur Folge hat. Da am Detektor nicht ohne Weiteres unterschieden werden kann, ob die gemessene Variation der Intensitätsverteilung auf Inhomogenitäten in der Reflektivität oder Unebenheiten in der untersuchten reflektierenden Fläche zurückzuführen ist, führen die genannten Interferenzeffekte zu einer Beeinträchtigung der Messgenauigkeit.

Zum Stand der Technik wird lediglich beispielhaft auf US 2,759,106, US 7,016,030 B2 sowie die Publikation U.D. Zeitner et al.: "Schwarzschild-Objective-Based EUV Micro Exposure Tool", SPIE-Proceedings Volume 6151, März 2006, verwiesen.

EP 1 249 698 A1 offenbart eine Reflektometeranordnung zur Bestimmung des Reflexionsvermögens ausgewählter Messorte von spektral abhängig reflektierenden Messobjekten mit einer polychromatisch emittierenden Strahlungsquelle, deren Strahlung als Messstrahlenbündel auf das Messobjekt gerichtet ist und mit einer Einrichtung zum Empfang von reflektierter Strahlung von dem ausgewählten Messort.

### ZUSAMMENFASSUNG DER ERFINDUNG

Aufgabe der vorliegenden Erfindung ist es, eine Messanordnung zur Messung optischer Eigenschaften eines reflektiven optischen Elements, insbesondere für die Mikrolithographie, bereitzustellen, welche eine hohe Ortsauflösung unter zumindest weitgehender Vermeidung der vorstehend beschriebenen Probleme ermöglicht.
Diese Aufgabe wird durch die Messanordnung gemäß den Merkmalen des unabhängigen Patentanspruchs 1 gelöst.
Eine erfindungsgemäße Messanordnung zur Messung optischer Eigenschaften eines reflektiven optischen Elements, insbesondere für die Mikrolithographie weist auf:
- eine EUV-Lichtquelle;
- einen Detektor zur Erfassung von an dem reflektiven optischen Element reflektierter EUV-Strahlung; und
- ein Abbildungssystem, welches Objektpunkte auf dem reflektiven optischen Element auf jeweils einen Bildpunkt auf dem Detektor abbildet;
- wobei das Abbildungssystem zur Reflexion der EUV-Strahlung eine erste optische Komponente und wenigstens eine zweite optische Komponente aufweist; und
- wobei sowohl an der ersten optischen Komponente als auch an der zweiten optischen Komponente die bei der Reflexion der EUV-Strahlung jeweils auftretenden, auf die jeweilige Oberflächennormale bezogenen Reflexionswinkel wenigstens 70° (entsprechend einem "streifenden Einfall") betragen.

Der Erfindung liegt insbesondere das Konzept zugrunde, durch Einsatz eines Abbildungssystems zwischen der zu untersuchenden reflektierenden Fläche des reflektiven optischen Elements ("Probe") und dem Detektor Orte bzw. Objektpunkte auf der Probe einzeln auf Orte bzw. Bildpunkte am Detektor abzubilden mit der Folge, dass auf jedem der betreffenden Bildpunkte auf dem Detektor immer nur die Intensität erzeugt wird, die von einem Ort bzw. Objektpunkt der reflektierenden Fläche des zu untersuchenden reflektiven optischen Elements bzw. der Probe herkommt.

Mit anderen Worten entspricht jeder Punkt auf dem Detektor (z.B. einer CCD-Kamera) genau einem Punkt auf der Probe und nicht mehr einem "Gemisch" aus mehreren (einen gemeinsamen Punkt auf der Kamera beleuchtenden) Punkten auf der Probe. Da immer nur ein (Objekt-)Punkt des zu untersuchenden reflektiven optischen Elements bzw. der Probe auf einen Punkt des Detektors abgebildet wird, ergibt sich somit keine Überlagerung von mehreren Intensitäten aus mehreren (Objekt-)Punkten der Probe auf einem (Bild-)Punkt auf dem Detektor mehr, so dass die eingangs beschriebenen, unerwünschten Interferenzmuster vermieden werden.

Im Ergebnis lassen sich so vergleichsweise hohe Ortsauflösungen (z.B. unterhalb von 100µm, insbesondere unterhalb von 20µm) erzielen.

Dadurch, dass ferner die in dem in der erfindungsgemäßen Messanordnung zwischen dem zu untersuchenden reflektiven optischen Element und dem Detektor eingesetzten Abbildungssystem vorhandenen optischen Komponenten jeweils unter streifendem Einfall betrieben werden, wird zudem eine - etwa im Falle einer Anordnung mit senkrechtem Lichteinfall vorhandene - schmalbandige Wellenlängenbegrenzung vermieden, so dass die Möglichkeit geschaffen wird, eine Breitband-Reflektometrie zu realisieren. Insbesondere kann ein Reflexionsspektrum von (Objekt-)Punkten auf der zu untersuchenden Probe ermittelt werden, so dass umfassendere Informationen hinsichtlich der Reflexionseigenschaften (z.B. auch die Höhe und spektrale Lage der maximalen Reflektivität und die Höhe und spektrale Lage der angrenzenden Reflexionsminima soweit vorhanden in einem Wellenlängenbereich) gewonnen und entsprechende Rückschlüsse auf Probeneigenschaften wie z.B. Reflexionsschichtdicken gezogen werden können.

Ein weiterer, erfindungsgemäß erzielter Vorteil besteht darin, dass etwa bei der Anwendung in der Mikroskopie aufgrund der durch die erfindungsgemäße Messanordnung bereitgestellten Breitbandigkeit auch eine hinreichend ortsaufgelöste bzw. kontrastreiche Untersuchung von Strukturen gelingt, welche einzelne, unter voneinander verschiedenen Wellenlängen reflektierende Teilstrukturen aufweisen. In einem solchen Falle kann - wie im Weiteren noch näher erläutert - anstelle einer mikroskopischen Untersuchung der Gesamtstruktur mit einer einzigen Wellenlänge eine mikroskopische Untersuchung in mehreren Teilschritten mit jeweils unterschiedlich eingestellter Wellenlänge bzw. Lichtquelle oder auch unter Verwendung einer hinreichend breitbandigen Lichtquelle erfolgen, so dass anstelle einer (bei Verwendung z.B. nur einer einzigen, mittleren Wellenlänge erzielten) einheitlichen Reflexion die Einzelstrukturen je nach eingesetzter Wellenlänge mit vergleichsweise hohem Kontrast aufgelöst werden können.

Gemäß einer Ausführungsform weisen die erste optische Komponente und die zweite optische Komponente jeweils einen kegelschnittförmigen Querschnitt auf.

Gemäß einer Ausführungsform ist die erste optische Komponente ein Ellipsoidspiegel. Bei der zweiten optischen Komponente kann es sich z.B. um einen Hyperboloidspiegel oder ebenfalls um einen Ellipsoidspiegel handeln. Dabei können insbesondere ein Brennpunkt der ersten optischen Komponente und ein Brennpunkt der zweiten optischen Komponente zusammenfallen.

Gemäß einer Ausführungsform weist der Detektor eine CCD-Kamera oder einen CMOS-Sensor auf.
Gemäß einer Ausführungsform ist das reflektive optische Element ein Spiegel einer mikrolithographischen Projektionsbelichtungsanlage.
Gemäß einer Ausführungsform ist das reflektive optische Element eine Spiegelfacette eines Facettenspiegels, insbesondere eines Feldfacettenspiegels oder eines Pupillenfacettenspiegels einer Beleuchtungseinrichtung einer mikrolithographischen Projektionsbelichtungsanlage.
Gemäß einer Ausführungsform ist das reflektive optische Element eine Mikrolithographie-Maske. Die Erfindung ist somit insbesondere auch in einem Maskeninspektionssystem zur Inspektion von Mikrolithographie-Masken vorteilhaft realisierbar.
Gemäß einer Ausführungsform ist die EUV-Lichtquelle eine Lichtquelle zur Erzeugung von EUV-Strahlung mit unterschiedlichen Wellenlängen über ein Wellenlängenintervall von wenigstens Δλ=1nm, insbesondere von wenigstens Δλ=3nm, weiter insbesondere von wenigstens Δλ=5nm, weiter insbesondere von wenigstens Δk=10nm, und weiter insbesondere wenigstens Δk=20nm. Die EUV-Lichtquelle kann als Breitband-Lichtquelle zur Erzeugung von EUV-Strahlung in einem kontinuierlichen Wellenlängenspektrum oder als auf unterschiedliche schmalbandige Wellenlängenbereiche einstellbare Lichtquelle ausgestaltet sein.

Gemäß einer Ausführungsform, die nicht Teil der Erfindung ist, weist die Messanordnung über ein vorgegebenes Wellenlängenintervall eine laterale Ortsauflösung (mitunter auch als Linienbreite oder CD= "critical dimension" bezeichnet) kleiner als 100µm, insbesondere kleiner als 50µm, weiter insbesondere kleiner als 20µm, und weiter insbesondere kleiner als 10µm, auf.

Gemäß einer Ausführungsform, die nicht Teil der Erfindung ist, beträgt dieses Wellenlängenintervall wenigstens Δλ=3nm, weiter insbesondere wenigstens Δλ=5nm, weiter insbesondere wenigstens Δλ=10nm, und weiter insbesondere wenigstens Δλ=20nm.

Ein weiterer Aspekt, der nicht Teil der Erfindung ist, betrifft eine Messanordnung zur Messung optischer Eigenschaften eines reflektiven optischen Elements, insbesondere für die Mikrolithographie, mit:
- einer EUV-Lichtquelle;
- einem Detektor zur Erfassung von an dem reflektiven optischen Element reflektierter EUV-Strahlung; und
- einem Abbildungssystem, welches Objektpunkte auf dem reflektiven optischen Element auf jeweils einen Bildpunkt auf dem Detektor abbildet;
- wobei die Messanordnung über ein vorgegebenes Wellenlängenintervall von wenigstens Δλ=3nm eine laterale Ortsauflösung kleiner als 100µm aufweist.
Die Erfindung betrifft weiter auch ein Maskeninspektionssystem, welches eine Messanordnung mit den vorstehend beschriebenen Merkmalen aufweist.
Die Erfindung betrifft weiter auch ein EUV-Mikroskop, welches eine Messanordnung mit den vorstehend beschriebenen Merkmalen aufweist.
Gemäß einem weiteren Aspekt betrifft die Erfindung auch ein Verfahren zur Messung optischer Eigenschaften eines reflektiven optischen Elements, insbesondere für die Mikrolithographie, wobei das reflektive optische Element mit EUV-Strahlung einer EUV-Lichtquelle beleuchtet wird und wobei mit einem Abbildungssystem Objektpunkte auf dem reflektiven optischen Element auf jeweils einen Bildpunkt auf einem Detektor abgebildet werden, wobei eine Messanordnung mit den vorstehend beschriebenen Merkmalen verwendet wird.

Gemäß einer Ausführungsform erfolgt das Abbilden der Objektpunkte auf dem reflektiven optischen Element auf jeweils einen Bildpunkt auf einem Detektor in einer Mehrzahl von Teilschritten, welche sich hinsichtlich der Arbeitswellenlänge bei dieser Abbildung voneinander unterscheiden. Hierdurch können, wie bereits vorstehend beschrieben, anstelle einer (bei Verwendung z.B. nur einer einzigen, mittleren Wellenlänge erzielten) einheitlichen Reflexion die Einzelstrukturen je nach eingesetzter Wellenlänge mit vergleichsweise hohem Kontrast aufgelöst werden.

Weitere Ausgestaltungen der Erfindung sind der Beschreibung sowie den Unteransprüchen zu entnehmen.

Die Erfindung wird nachstehend anhand von in den beigefügten Abbildungen dargestellten Ausführungsbeispielen näher erläutert.

### KURZE BESCHREIBUNG DER ZEICHNUNGEN

Es zeigen:
- Figur 1: eine schematische Darstellung einer erfindungsgemäßen Messanordnung;
- Figur 2a-2f: schematische Darstellungen zur Erläuterung unterschiedlicher Ausführungsformen eines in der erfindungsgemäßen Messanordnung einsetzbaren Abbildungssystems;
- Figur 3: eine schematische Darstellung zur Erläuterung eines konkreten Ausführungsbeispiels der vorliegenden Erfindung;
- Figur 4: eine schematische Darstellung zur Erläuterung einer möglichen Anwendung der vorliegenden Erfindung in einem Maskeninspektionssystem;
- Figur 5: eine schematische Darstellung zur Erläuterung einer weiteren Anwendung der Erfindung in einem EUV-Mikroskop; und
- Figur 6: eine schematische Darstellung des möglichen Aufbaus einer mikrolithographischen Projektionsbelichtungsanlage.

### DETAILLIERTE BESCHREIBUNG BEVORZUGTER AUSFÜHRUNGSFORMEN

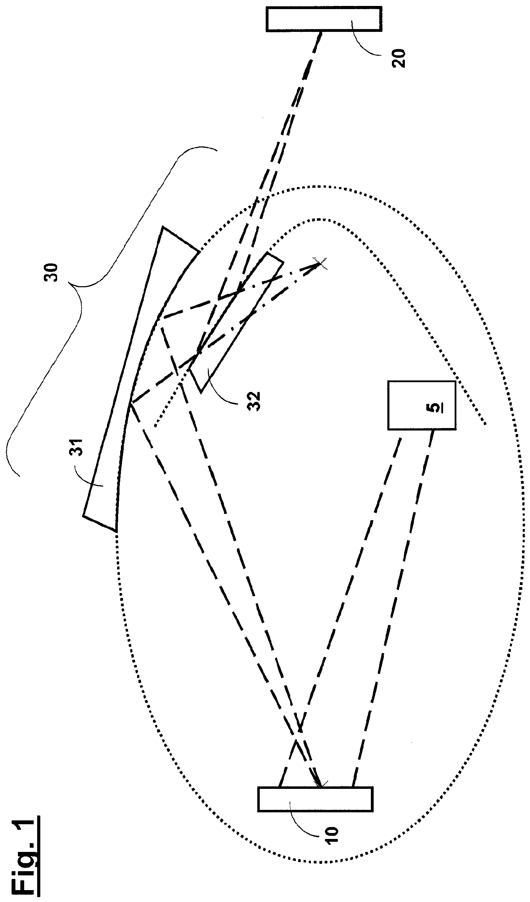

Im Weiteren wird zunächst der prinzipielle Aufbau einer erfindungsgemäßen Messanordnung zur Messung der Reflexionseigenschaften eines reflektiven optischen Elements für die Mikrolithographie anhand eines Ausführungsbeispiels unter Bezugnahme auf die schematische Abbildung von Fig. 1 beschrieben.

In dieser Messanordnung wird gemäß Fig. 1 ein Detektor 20 in Form einer CCD-Kamera im Abbild eines von einer EUV-Lichtquelle 5 mit elektromagnetischer EUV-Strahlung bestrahlten reflektiven optischen Elementes 10 angeordnet. Die Abbildung der von der EUV-Lichtquelle 5 emittierten und vom reflektiven optischen Element 10 reflektierten EUV-Strahlung auf die CCD-Kamera erfolgt durch ein Abbildungssystem 30, welches im Ausführungsbeispiel von Fig. 1 eine erste optische Komponente 31 in Form eines Ellipsoidspiegels und eine zweite optische Komponente 32 in Form eines Hyperboloidspiegels aufweist (wobei der Verlauf der entsprechenden Ellipse bzw. Hyperbel in Fig. 1 jeweils durch eine gepunktete Linie dargestellt ist). Das reflektive optische Element 10 kann sich dabei entweder im Fernfeld oder in einem Fokus der EUV-Lichtquelle 5 befinden.

Dabei erfolgt an den optischen Komponenten 31 und 32 des Abbildungssystems 30 jeweils ein "streifender Einfall" dahingehend, dass der Reflexionswinkel der elektromagnetischen EUV-Strahlung zum Lot an der betreffenden optischen Komponente 31 bzw. 32 wenigstens 70° beträgt.

In weiteren Ausführungsformen kann als Detektor 20 auch ein CMOS-Sensor eingesetzt werden. Des Weiteren kann ein als Detektor 20 eingesetzter (CMOS- oder CCD-)Sensor auch mit rückwärtiger Belichtung ausgestaltet sein. Ferner kann der entsprechende Bildsensor auch mit einer Fluoreszenzschicht (z.B. zur Umwandlung von elektromagnetischer EUV-Strahlung in sichtbares Licht zwecks vereinfachter Detektion) versehen sein.

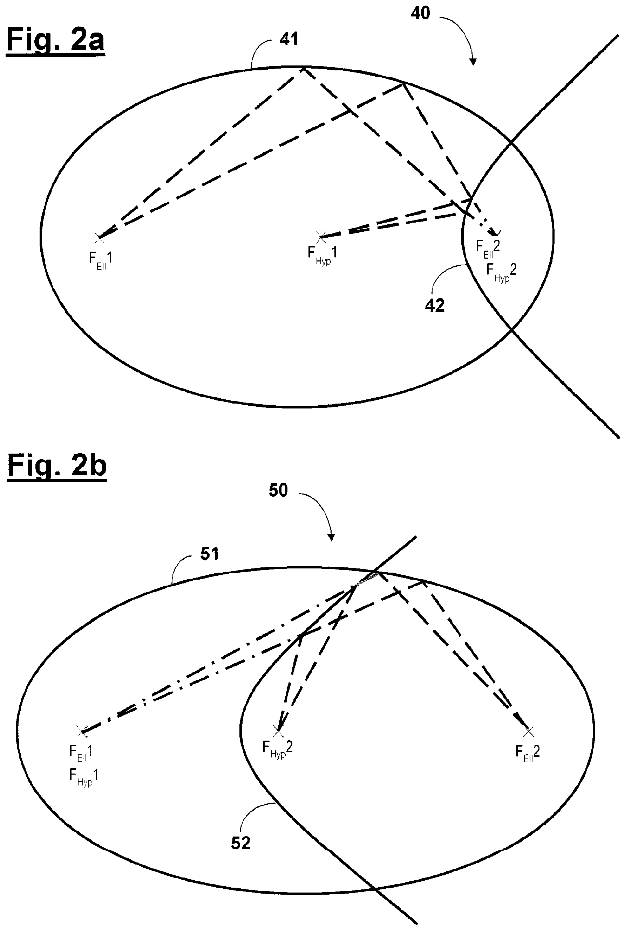

Fig. 2a-f zeigen schematische Darstellungen zur Erläuterung weiterer unterschiedlicher Ausführungsformen eines in der erfindungsgemäßen Messanordnung einsetzbaren Abbildungssystems. Die Darstellungen von 2a-2f dienen dabei lediglich zur Veranschaulichung unterschiedlicher Kombinationsmöglichkeiten von optischen Komponenten in dem betreffenden Abbildungssystem, wobei jeweils noch durch geeignete Wahl der Parameter dieser optischen Komponenten (d.h. des jeweiligen Ellipsoidspiegels bzw. Hyperboloidspiegels) noch der o.g. streifende Einfall auf die betreffenden Spiegeloberflächen in zu Fig. 1 analoger Weise sicherzustellen ist.

Gemäß Fig. 2a kann ein in der erfindungsgemäßen Messanordnung eingesetztes Abbildungssystem 40 eine erste optische Komponente 41 in Form eines Ellipsoidspiegels und eine zweite optische Komponente 42 in Form eines Hyperboloidspiegels aufweisen, wobei der zweite Brennpunkt des Ellipsoids und der zweite Brennpunkt des Hyperboloids zusammenfallen und wobei die konvexe Seite der Hyperbel verwendet wird.

Gemäß Fig. 2b kann in einer weiteren Ausführungsform ein in der erfindungsgemäßen Messanordnung eingesetztes Abbildungssystem 50 eine erste optische Komponente 51 in Form eines Ellipsoidspiegels und eine zweite optische Komponente 52 in Form eines Hyperboloidspiegels aufweisen, wobei der erste Brennpunkt des Hyperboloids und der erste Brennpunkt des Ellipsoids zusammenfallen und wobei die konkave Seite des Hyperboloids verwendet wird (dieses System kann auch als "Wolter Typ I-System" bezeichnet werden).

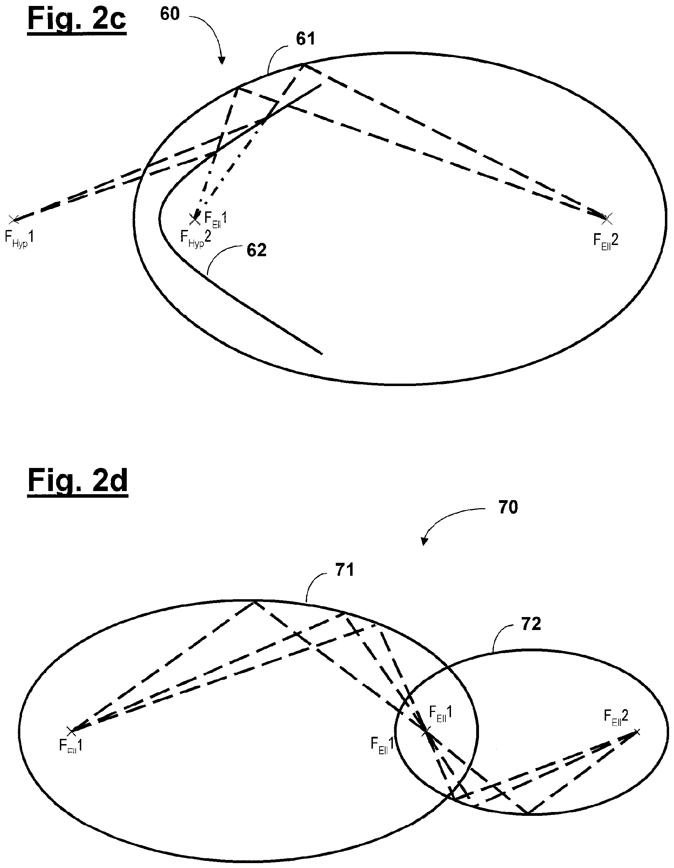

Gemäß Fig. 2c kann in einer weiteren Ausführungsform ein in der erfindungsgemäßen Messanordnung eingesetztes Abbildungssystem 60 eine erste optische Komponente 61 in Form eines Ellipsoidspiegels und eine zweite optische Komponente 62 in Form eines Hyperboloidspiegels aufweisen, wobei der zweite Brennpunkt des Hyperboloids und der erste Brennpunkt des Ellipsoids zusammenfallen (dieses System kann auch als "Wolter Typ II-System" bezeichnet werden).

Gemäß Fig. 2d kann ein in einer weiteren Ausführungsform in der erfindungsgemäßen Messanordnung eingesetztes Abbildungssystem 70 eine erste optische Komponente 71 in Form eines Ellipsoidspiegels und eine zweite optische Komponente 72 in Form eines Ellipsoidspiegels aufweisen, wobei der zweite Brennpunkt des ersten Ellipsoids und der erste Brennpunkt des zweiten Ellipsoids zusammenfallen.

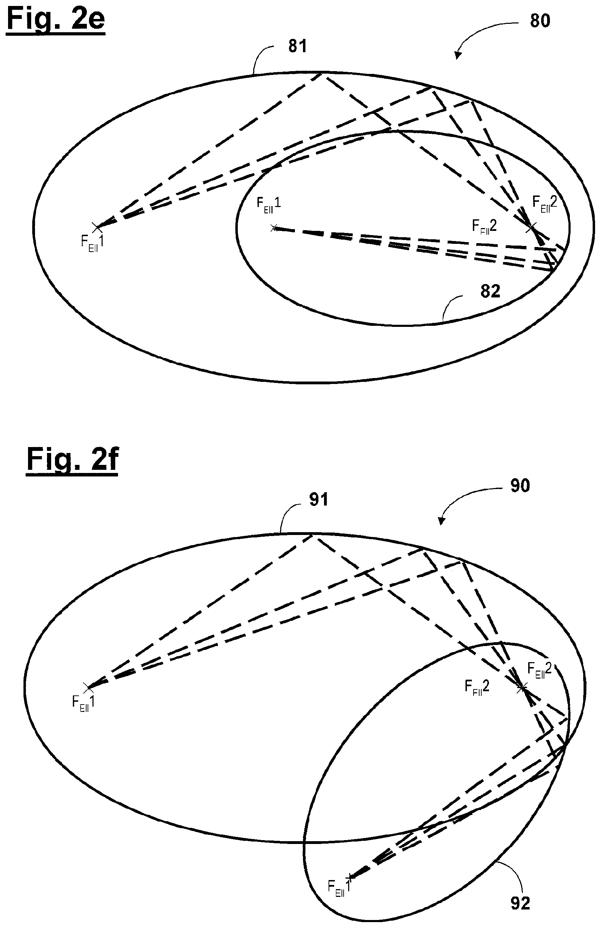

Gemäß Fig. 2e kann in einer weiteren Ausführungsform ein in der erfindungsgemäßen Messanordnung eingesetztes Abbildungssystem 80 eine erste optische Komponente 81 in Form eines Ellipsoidspiegels und eine zweite optische Komponente 82 in Form eines Ellipsoidspiegels aufweisen, wobei der zweite Brennpunkt des ersten Ellipsoids und der zweite Brennpunkt des zweiten Ellipsoids zusammenfallen.

Wenngleich in den vorstehend beschriebenen Ausführungsformen jeweils die Rotationsachsen der betreffenden optischen Komponenten des Abbildungssystems zusammenfallen, ist die Erfindung nicht hierauf beschränkt. Zur Veranschaulichung zeigt lediglich beispielhaft Fig. 2f eine gegenüber Fig. 2e modifizierte Anordnung, in der in einem Abbildungssystem 90 die zweite optische Komponente 92 in Form des Ellipsoidspiegels mit der Rotationsachse des Ellipsoids gegenüber der ersten optischen Komponente 91 verdreht ist.

Des Weiteren können die in Fig. 2a-f dargestellten Kombinationen von optischen Komponenten im betreffenden Abbildungssystem für beide (einander entgegengesetzte) Lichtausbreitungsrichtungen realisiert werden. Ferner sind die optischen Komponenten im betreffenden Abbildungssystem nicht notwendigerweise rotationssymmetrisch. Die dargestellten Kombinationen können auch jeweils mit planelliptischen bzw. plan-hyperboloiden Spiegeln realisiert werden.

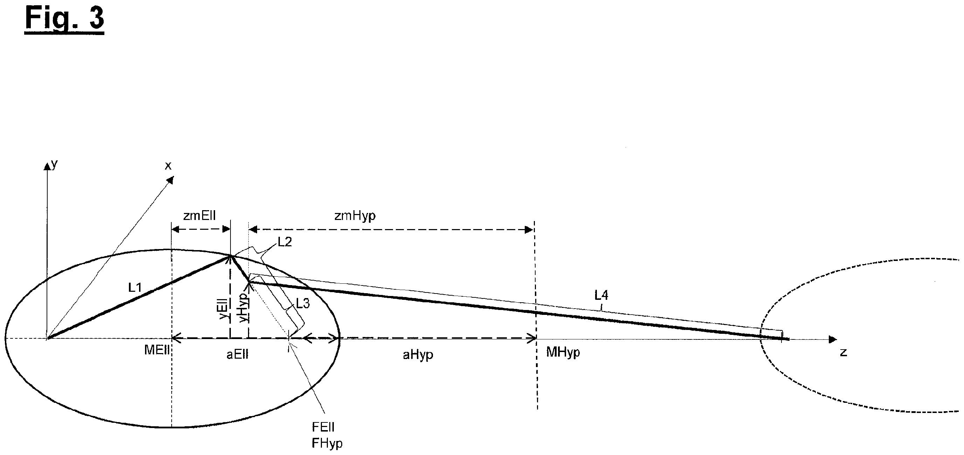

In Tabelle 1 und Tabelle 2 sind lediglich beispielhaft und zur Angabe eines konkreten Ausführungsbeispiels die Designdaten eines in der erfindungsgemäßen Messanordnung einsetzbaren Abbildungssystems, welches den anhand von Fig. 1 bzw. Fig. 2a beschriebenen prinzipiellen Aufbau aufweist, angegeben. Fig. 3 dient zur Veranschaulichung bzw. Definition der in Tabelle 1 und 2 enthaltenen Spiegelparameter.

Vorteilhaft an diesem Design ist insbesondere, dass die beiden optischen Komponenten bzw. Spiegel des Abbildungssystems relativ nahe beieinander stehen, wobei diese Spiegel außerhalb der eigentlichen Messanordnung in geeigneter Weise zueinander in der erforderlichen Justagegenauigkeit (die z.B. in der Größenordnung von 1µm liegen kann) justiert und dann gemeinsam in die Messanordnung eingebaut werden können.

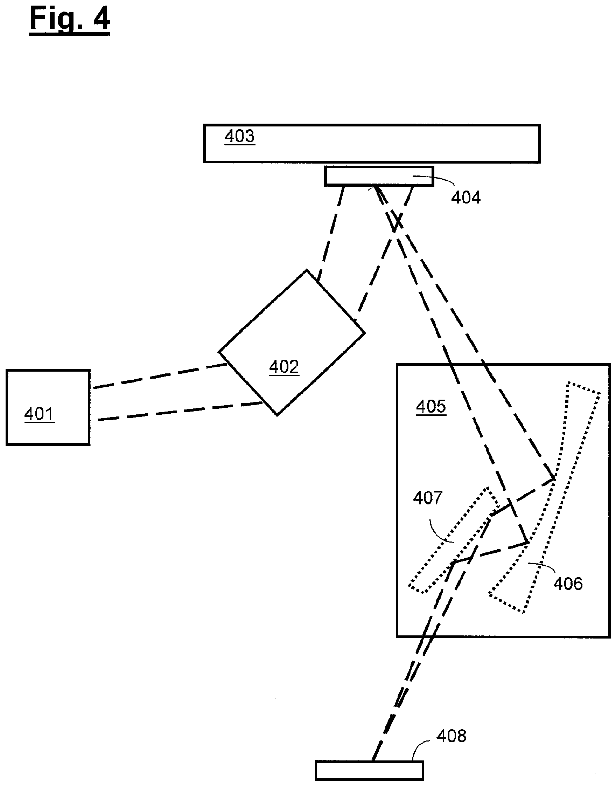

Fig. 4 zeigt in lediglich schematischer Darstellung den möglichen Aufbau eines Maskeninspektionssystems zur Inspektion von Mikrolithographie-Masken unter Einsatz einer erfindungsgemäßen Messanordnung.

Gemäß Fig. 4 trifft elektromagnetische Strahlung (z.B. mit einer Wellenlänge im EUV-Bereich) einer Lichtquelle 401 auf eine Beleuchtungsoptik 402 zur Ausleuchtung einer auf einem Maskentisch 403 befindlichen Mikrolithographie-Maske 404. Die Lichtquelle 401 kann z.B. eine einstellbare Wellenlänge (beispielsweise 6.7nm oder 13.5nm) aufweisen. In weiteren Ausführungsformen kann die Lichtquelle 401 auch als breitbandige Lichtquelle (welche z.B. sowohl elektromagnetische Strahlung mit einer Wellenlänge von 6.7nm als auch elektromagnetische Strahlung mit einer Wellenlänge von 13.5nm erzeugt) ausgestaltet sein. Des Weiteren kann die Beleuchtungsoptik 402 eine einstellbare Wellenlängenselektion aufweisen.

Die an der Mikrolithographie-Maske 404 reflektierte, elektromagnetische Strahlung trifft gemäß Fig. 4 auf ein Abbildungssystem 405, welches gemäß den vorstehend beschriebenen Ausführungsformen ausgestaltet sein kann und insbesondere gemäß den o.g. Ausführungsformen ausgestaltete optische Komponenten 406 und 407 aufweist. Die von dem Abbildungssystem 405 ausgehende, elektromagnetisehe Strahlung trifft analog zu den vorstehend beschriebenen Ausführungsformen auf einen Detektor 408 (z.B. eine CCD-Kamera oder einen CMOS-Sensor).

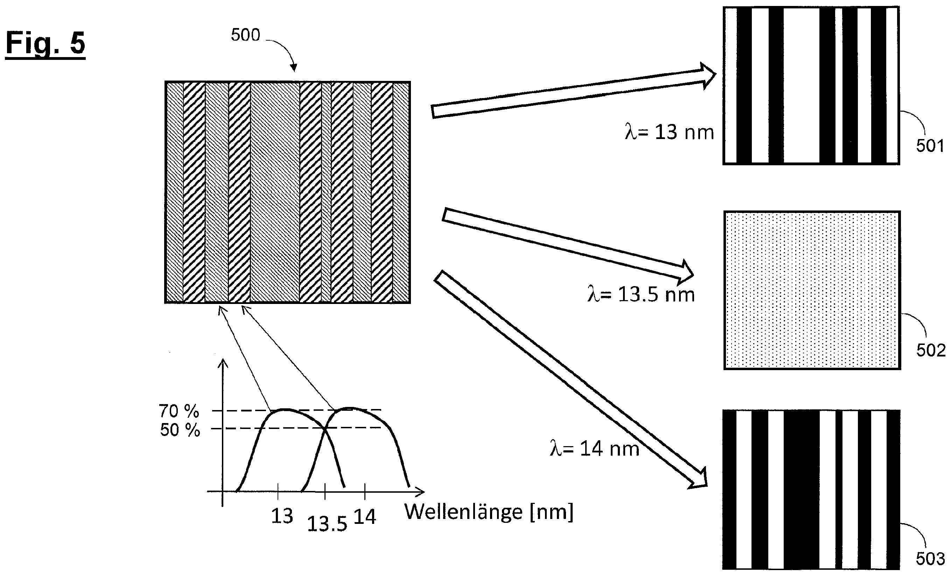

Fig. 5 zeigt eine schematische Darstellung zur Erläuterung einer weiteren vorteilhaften Anwendung der Erfindung in einem Mikroskop, insbesondere einem EUV-Mikroskop mit variabler Wellenlänge. In Fig. 5 ist mit "500" eine mikroskopisch zu untersuchende Probe dargestellt, welche in dem dargestellten, einfachen Ausführungsbeispiel ein Streifenmuster aus Streifen 501a, 501b,... einer ersten Schichtdicke und Streifen 502a, 502b,... mit einer von der ersten Schichtdicke verschiedenen zweiten Schichtdicke aufweist, wobei der im Diagramm von Fig. 5 schematisch aufgetragene Reflexionsgrad sein Maximum von 70% für diese Streifen bei voneinander verschiedenen Wellenlängen (ca. 13nm bzw. ca. 14nm) besitzt. Wie in Fig. 5 lediglich schematisch dargestellt ist, würde eine mikroskopische Untersuchung unter Verwendung einer einzigen Wellenlänge von 13.5nm nur ein kontrastarmes Abbild 502 mit im Wesentlichen gleichförmiger Intensität liefern, wohingegen die mikroskopische Untersuchung sowohl bei einer ersten Wellenlänge von 13nm als auch einer zweiten Wellenlänge von 14nm für beide Muster von Streifen 501a, 501b,... und 502a, 502b,... jeweils kontrastreich aufgelöste Abbilder 501 bzw. 503 liefert. Die mit der erfindungsgemäßen Messanordnung erzielbare Breitbandigkeit kann mit anderen Worten also dazu genutzt werden, unterschiedliche Strukturen, welche bei voneinander verschiedenen Wellenlängen elektromagnetische Strahlung reflektieren, mit erhöhtem Kontrast bzw. hoher Ortsauflösung mikroskopisch zu untersuchen.

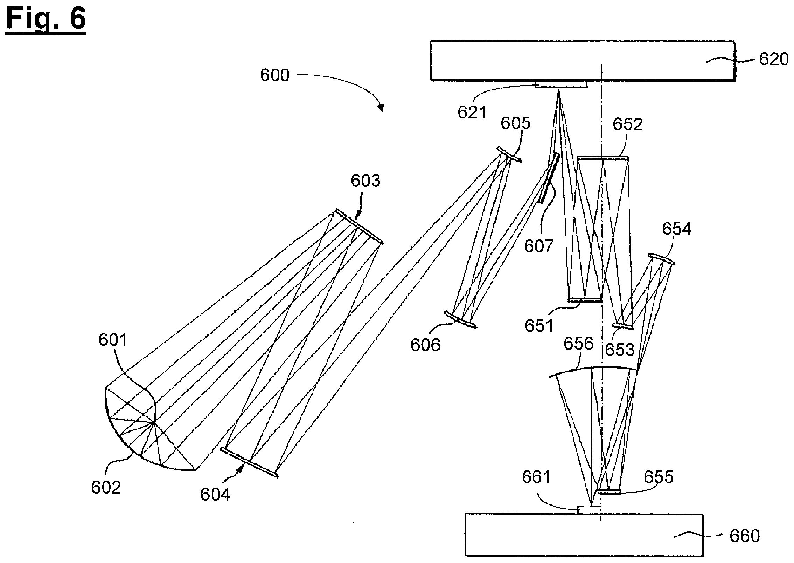

In weiteren Anwendungen kann die erfindungsgemäße Messanordnung auch zur Bestimmung der Reflexionseigenschaften eines Spiegels einer mikrolithographischen Projektionsbelichtungsanlage, die insbesondere für den Betrieb im EUV ausgelegt sein kann, verwendet werden. Fig. 6 zeigt hierzu eine lediglich schematische Darstellung einer beispielhaften, für den Betrieb im EUV ausgelegten Projektionsbelichtungsanlage.

Gemäß Fig. 6 weist eine Beleuchtungseinrichtung in einer für EUV ausgelegten Projektionsbelichtungsanlage 600 einen Feldfacettenspiegel 603 und einen Pupillenfacettenspiegel 604 auf. Auf den Feldfacettenspiegel 603 wird das Licht einer Lichtquelleneinheit, welche eine Plasmalichtquelle 601 und einen Kollektorspiegel 602 umfasst, gelenkt. Im Lichtweg nach dem Pupillenfacettenspiegel 604 sind ein erster Teleskopspiegel 605 und ein zweiter Teleskopspiegel 606 angeordnet. Im Lichtweg nachfolgend ist ein Umlenkspiegel 607 angeordnet, der die auf ihn treffende Strahlung auf ein Objektfeld in der Objektebene eines sechs Spiegel 651-656 umfassenden Projektionsobjektivs lenkt. Am Ort des Objektfeldes ist eine reflektive strukturtragende Maske 621 auf einem Maskentisch 620 angeordnet, die mit Hilfe des Projektionsobjektivs in eine Bildebene abgebildet wird, in welcher sich ein mit einer lichtempfindlichen Schicht (Photoresist) beschichtetes Substrat 661 auf einem Wafertisch 660 befindet.
Wenn die Erfindung auch anhand spezieller Ausführungsformen beschrieben wurde, erschließen sich für den Fachmann zahlreiche Variationen und alternative Ausführungsformen, z.B. durch Kombination und/oder Austausch von Merkmalen einzelner Ausführungsformen. Dementsprechend versteht es sich für den Fachmann, dass derartige Variationen und alternative Ausführungsformen von der vorliegenden Erfindung mit umfasst sind, und die Reichweite der Erfindung nur im Sinne der beigefügten Patentansprüche beschränkt ist.

**Tabelle 1: Designdaten Ellipsoid**

| **Beschreibung** | **Bez.** | **Wert** | **Einheiten** |
|---|---|---|---|
| Radius im Scheitelpunkt | r | -39.317038 | mm |
| Konische Konstante | k | -0.952999221 | |
| Numerische Exzentrizität | eps | 0.97621679 | |
| Halbachse in z-Richtung | aEII | -836.5188585 | mm |
| Halbachse in y-Richtung | b | 181.3544699 | mm |
| Lineare Exzentrizität | e | -816.6237548 | mm |

| **Lageangabe bezüglich Flächenscheitel** | | | |
|---|---|---|---|
| Mittelpunkt in z-Richtung (= a) | z | -836.5188585 | mm |
| Zielpunkt in y-Richtung | yEII | 151.779 | mm |
| Zielpunkt in z-Richtung | zEII | -378.67 | mm |
| Ausdehnung: | | | |
| Von | z1 | -353 | mm |
| Bis | z2 | -404 | mm |
| Von (relativ zum Zielpunkt) | z1r | -25.67 | mm |
| Bis (relativ zum Zielpunkt) | z2r | 25.33 | mm |
| Breite | 2x | 13.2 | mm |

| **Lageangaben bezüglich Mittelpunkt (MEII)** | | | |
|---|---|---|---|
| Zielpunkt in z-Richtung | zmEII | 457.8488585 | mm |

| **Angaben zum Dreieck aus Zielpunkt und Brennpunkten** | | | |
|---|---|---|---|
| Schenkel 1 | L1 | 1291.37751 | mm |
| Schenkel 2 | L2 | 381.6602071 | mm |
| Halber Ablenkwinkel am Zielpunkt | Theta | 14.81934 | ° |

**Tabelle 2: Designdaten Hyperboloid**

| **Beschreibung** | **Bez.** | **Wert** | **Einheiten** |
|---|---|---|---|
| Radius im Scheitelpunkt | r | -15.055952 | mm |
| Konische Konstante | k | -1.004191885 | |
| Numerische Exzentrizität | eps | 1.002093751 | |
| Halbachse in z-Richtung | aHyp | 3591.690135 | mm |
| Halbachse in y-Richtung | b | 232.543145 | mm |
| Lineare Exzentrizität | e | 3599.210238 | mm |

| **Lageangabe bezüglich Flächenscheitel** | | | |
|---|---|---|---|
| Mittelpunkt in z-Richtung (= a) | z | 3591.690135 | mm |
| Zielpunkt in y-Richtung | yHyp | 75.939 | mm |
| Zielpunkt in z-Richtung | zHyp | -186.662 | mm |
| Ausdehnung: | | | |
| Von | z1 | -169 | mm |
| Bis | z2 | -204 | mm |
| Von (relativ zum Zielpunkt) | z1r | -17.662 | mm |
| Bis (relativ zum Zielpunkt) | z2r | 17.338 | mm |
| Breite | 2x | 7 | mm |

| **Lageangaben bezüglich Mittelpunkt (MHyp)** | | | |
|---|---|---|---|
| Zielpunkt in z-Richtung | zmHyp | -3778.352135 | mm |

| **Angaben zum Dreieck aus Zielpunkt und Brennpunkten** | | | |
|---|---|---|---|
| Schenkel 1 | L3 | -186.6727871 | mm |
| Schenkel 2 | L4 | 6461.31911 | mm |
| Halber Ablenkwinkel am Zielpunkt | Theta | 11.10787 | ° |

## Patentansprüche

1. Messanordnung zur Messung optischer Eigenschaften eines reflektiven optischen Elements, insbesondere für die Mikrolithographie, mit:
• einer EUV-Lichtquelle (5);
• einem Detektor (20) zur Erfassung von an dem reflektiven optischen Element (10) reflektierter EUV-Strahlung; und
• einem Abbildungssystem (30, 40, 50, 60, 70, 80, 90), welches Objektpunkte auf dem reflektiven optischen Element (10) auf jeweils einen Bildpunkt auf dem Detektor (20) abbildet;
• wobei das Abbildungssystem zur Reflexion der EUV-Strahlung eine erste optische Komponente (31, 41, 51, 61, 71, 81, 91) und wenigstens eine zweite optische Komponente (32, 42, 52, 62, 72, 82, 92) aufweist; und
• wobei sowohl an der ersten optischen Komponente (31, 41, 51, 61, 71, 81, 91) als auch an der zweiten optischen Komponente (32, 42, 52, 62, 72, 82, 92) die bei der Reflexion der EUV-Strahlung jeweils auftretenden, auf die jeweilige Oberflächennormale bezogenen Reflexionswinkel wenigstens 70° betragen.

2. Messanordnung nach Anspruch 1, **dadurch gekennzeichnet, dass** die erste optische Komponente (31, 41, 51, 61, 71, 81, 91) und die zweite optische Komponente (32, 42, 52, 62, 72, 82, 92) jeweils einen kegelschnittförmigen Querschnitt aufweisen.

3. Messanordnung nach Anspruch 1 oder 2, **dadurch gekennzeichnet, dass** die erste optische Komponente (31, 41, 51, 61, 71, 81, 91) ein Ellipsoidspiegel ist.

4. Messanordnung nach einem der Ansprüche 1 bis 3, **dadurch gekennzeichnet, dass** die zweite optische Komponente (32, 42, 52, 62) ein Hyperboloidspiegel ist.

5. Messanordnung nach einem der Ansprüche 1 bis 3, **dadurch gekennzeichnet, dass** die zweite optische Komponente (72, 82, 92) ein Ellipsoidspiegel ist.

6. Messanordnung nach einem der vorhergehenden Ansprüche, **dadurch gekennzeichnet, dass** ein Brennpunkt der ersten optischen Komponente (31, 41, 51, 61, 71, 81, 91) und ein Brennpunkt der zweiten optischen Komponente (32, 42, 52, 62, 72, 82, 92) zusammenfallen.

7. Messanordnung nach einem der vorhergehenden Ansprüche, **dadurch gekennzeichnet, dass** der Detektor (20) eine CCD-Kamera oder einen CMOS-Sensor aufweist.

8. Messanordnung nach einem der Ansprüche 1 bis 7, **dadurch gekennzeichnet, dass** das reflektive optische Element (10) ein Spiegel einer mikrolithographischen Projektionsbelichtungsanlage ist.

9. Messanordnung nach einem der Ansprüche 1 bis 7, **dadurch gekennzeichnet, dass** das reflektive optische Element (10) eine Spiegelfacette eines Facettenspiegels, insbesondere eines Feldfacettenspiegels oder eines Pupillenfacettenspiegels, einer Beleuchtungseinrichtung einer mikrolithographischen Projektionsbelichtungsanlage ist.

10. Messanordnung nach einem der vorhergehenden Ansprüche 1 bis 7, **dadurch gekennzeichnet, dass** das reflektive optische Element eine Mikrolithographie-Maske ist.

11. Messanordnung nach einem der vorhergehenden Ansprüche, **dadurch gekennzeichnet, dass** die EUV-Lichtquelle (5) eine breitbandige oder einstellbare Lichtquelle zur Erzeugung von EUV-Strahlung mit unterschiedlichen Wellenlängen über ein Wellenlängenintervall von wenigstens Δλ=1nm, insbesondere von wenigstens Δλ=3nm, weiter insbesondere von wenigstens Δλ=5nm, weiter insbesondere von wenigstens Δλ=10nm, und weiter insbesondere von wenigstens Δλ=20nm, ist.

12. Maskeninspektionssystem, **dadurch gekennzeichnet, dass** dieses eine Messanordnung nach einem der Ansprüche 1 bis 11 aufweist.

13. EUV-Mikroskop, **dadurch gekennzeichnet, dass** dieses eine Messanordnung nach einem der Ansprüche 1 bis 11 aufweist.

14. Verfahren zur Messung optischer Eigenschaften eines reflektiven optischen Elements, insbesondere für die Mikrolithographie, wobei das reflektive optische Element (10) mit EUV-Strahlung einer EUV-Lichtquelle (5) beleuchtet wird und wobei mit einem Abbildungssystem (30, 40, 50, 60, 70, 80, 90) Objektpunkte auf dem reflektiven optischen Element (10) auf jeweils einen Bildpunkt auf einem Detektor (20) abgebildet werden, **dadurch gekennzeichnet, dass** hierbei eine Messanordnung nach einem der Ansprüche 1 bis 11 verwendet wird.

15. Verfahren nach Anspruch 14, **dadurch gekennzeichnet, dass** das Abbilden der Objektpunkte auf dem reflektiven optischen Element (10) auf jeweils einen Bildpunkt auf einem Detektor (20) in einer Mehrzahl von Teilschritten erfolgt, welche sich hinsichtlich der Arbeitswellenlänge bei dieser Abbildung voneinander unterscheiden.

## Claims

1. Measuring arrangement for measuring optical properties of a reflective optical element, in particular for microlithography, with:
• an EUV light source (5);
• a detector (20) for detecting EUV radiation reflected at the reflective optical element (10); and
• an imaging system (30, 40, 50, 60, 70, 80, 90), which images object points on the reflective optical element (10) onto in each case an image point on the detector (20);
• wherein the imaging system has for the reflection of the EUV radiation a first optical component (31, 41, 51, 61, 71, 81, 91) and at least one second optical component (32, 42, 52, 62, 72, 82, 92); and
• wherein, both at the first optical component (31, 41, 51, 61, 71, 81, 91) and at the second optical component (32, 42, 52, 62, 72, 82, 92), the reflection angles in relation to the respective surface normal that respectively occur during the reflection of the EUV radiation are at least 70°.

2. Measuring arrangement according to Claim 1, **characterized in that** the first optical component (31, 41, 51, 61, 71, 81, 91) and the second optical component (32, 42, 52, 62, 72, 82, 92) respectively have a conic cross section.

3. Measuring arrangement according to Claim 1 or 2, **characterized in that** the first optical component (31, 41, 51, 61, 71, 81, 91) is an ellipsoid mirror.

4. Measuring arrangement according to one of Claims 1 to 3, **characterized in that** the second optical component (32, 42, 52, 62) is a hyperboloid mirror.

5. Measuring arrangement according to one of Claims 1 to 3, **characterized in that** the second optical component (72, 82, 92) is an ellipsoid mirror.

6. Measuring arrangement according to one of the preceding claims, **characterized in that** a focal point of the first optical component (31, 41, 51, 61, 71, 81, 91) and a focal point of the second optical component (32, 42, 52, 62, 72, 82, 92) coincide.

7. Measuring arrangement according to one of the preceding claims, **characterized in that** the detector (20) has a CCD camera or a CMOS sensor.

8. Measuring arrangement according to one of Claims 1 to 7, **characterized in that** the reflective optical element (10) is a mirror of a microlithographic projection exposure apparatus.

9. Measuring arrangement according to one of Claims 1 to 7, **characterized in that** the reflective optical element (10) is a mirror facet of a facet mirror, in particular a field facet mirror or a pupil facet mirror, of an illumination device of a microlithographic projection exposure apparatus.

10. Measuring arrangement according to one of the preceding Claims 1 to 7, **characterized in that** the reflective optical element is a microlithography mask.

11. Measuring arrangement according to one of the preceding claims, **characterized in that** the EUV light source (5) is a broadband or adjustable light source for generating EUV radiation with different wavelengths over a wavelength interval of at least Δλ = 1 nm, in particular of at least Δλ = 3 nm, more particularly of at least Δλ = 5 nm, more particularly of at least Δλ = 10 nm, and more particularly of at least Δλ = 20 nm.

12. Mask inspection system, **characterized in that** it has a measuring arrangement according to one of Claims 1 to 11.

13. EUV microscope, **characterized in that** it has a measuring arrangement according to one of Claims 1 to 11.

14. Method for measuring optical properties of a reflective optical element, in particular for microlithography, wherein the reflective optical element (10) is illuminated with EUV radiation of an EUV light source (5) and wherein object points on the reflective optical element (10) are imaged with an imaging system (30, 40, 50, 60, 70, 80, 90) onto in each case an image point on a detector (20), **characterized in that** a measuring arrangement according to one of Claims 1 to 11 is used for this.

15. Method according to Claim 14, **characterized in that** the imaging of the object points on the reflective optical element (10) onto in each case an image point on a detector (20) is performed in a plurality of substeps, which differ from one another with regard to the operating wavelength in this imaging.

## Revendications

1. Arrangement de mesure pour la mesure des propriétés optiques d'un élément optique réfléchissant, en particulier pour la microlithographie, comprenant :
• une source de lumière EUV (5) ;
• un détecteur (20) pour détecter un rayonnement EUV réfléchi sur l'élément optique réfléchissant (10) ; et
• un système de formation d'image (30, 40, 50, 60, 70, 80, 90) qui représente des points d'objet sur l'élément optique réfléchissant (10) sur respectivement un pixel sur le détecteur (20) ;
• dans lequel le système de formation d'image présente un premier composant optique (31, 41, 51, 61, 71, 81, 91) et au moins un deuxième composant optique (32, 42, 52, 62, 72, 82, 92) pour réfléchir le rayonnement EUV ; et
• dans lequel aussi bien sur le premier composant optique (31, 41, 51, 61, 71, 81, 91) que sur le deuxième composant optique (32, 42, 52, 62, 72, 82, 92), les angles de réflexion qui se produisent respectivement lors de la réflexion du rayonnement EUV par rapport à la normale de la surface correspondante sont d'au moins 70°.

2. Arrangement de mesure selon la revendication 1, **caractérisé en ce que** le premier composant optique (31, 41, 51, 61, 71, 81, 91) et le deuxième composant optique (32, 42, 52, 62, 72, 82, 92) présentent respectivement une section transversale de forme conique.

3. Arrangement de mesure selon la revendication 1 ou 2, **caractérisé en ce que** le premier composant optique (31, 41, 51, 61, 71, 81, 91) est un miroir ellipsoïdal.

4. Arrangement de mesure selon l'une quelconque des revendications 1 à 3, **caractérisé en ce que** le deuxième composant optique (32, 42, 52, 62) est un miroir hyperboloïde.

5. Arrangement de mesure selon l'une quelconque des revendications 1 à 3, **caractérisé en ce que** le deuxième composant optique (72, 82, 92) est un miroir ellipsoïdal.

6. Arrangement de mesure selon l'une quelconque des revendications précédentes, **caractérisé en ce qu'**un foyer du premier composant optique (31, 41, 51, 61, 71, 81, 91) et un foyer du deuxième composant optique (32, 42, 52, 62, 72, 82, 92) coïncident.

7. Arrangement de mesure selon l'une quelconque des revendications précédentes, **caractérisé en ce que** le détecteur (20) présente une caméra CCD ou un capteur CMOS.

8. Arrangement de mesure selon l'une quelconque des revendications 1 à 7, **caractérisé en ce que** l'élément optique réfléchissant (10) est un miroir d'une installation d'exposition par projection microlithographique.

9. Arrangement de mesure selon l'une quelconque des revendications 1 à 7, **caractérisé en ce que** l'élément optique réfléchissant (10) est une facette de miroir d'un miroir à facettes, en particulier d'un miroir à facettes de champ ou d'un miroir à facettes de pupille, d'un équipement d'éclairage d'une installation d'exposition par projection microlithographique.

10. Arrangement de mesure selon l'une quelconque des revendications précédentes 1 à 7, **caractérisé en ce que** l'élément optique réfléchissant est un masque de microlithographie.

11. Arrangement de mesure selon l'une quelconque des revendications précédentes, **caractérisé en ce que** la source de lumière EUV (5) est une source de lumière à large bande ou réglable pour produire un rayonnement EUV de différentes longueurs d'onde sur un intervalle de longueurs d'onde d'au moins Δλ = 1 nm, en particulier d'au moins Δλ = 3 nm, plus particulièrement d'au moins Δλ = 5 nm, plus particulièrement d'au moins Δλ = 10 nm, et plus particulièrement d'au moins Δλ = 20 nm.

12. Système d'inspection de masque, **caractérisé en ce qu'**il présente un arrangement de mesure selon l'une quelconque des revendications 1 à 11.

13. Microscope EUV, **caractérisé en ce qu'**il présente un arrangement de mesure selon l'une quelconque des revendications 1 à 11.

14. Procédé permettant de mesurer des propriétés optiques d'un élément optique réfléchissant, en particulier pour la microlithographie, l'élément optique réfléchissant (10) étant éclairé par un rayonnement EUV d'une source de lumière EUV (5), et dans lequel un système de formation d'image (30, 40, 50, 60, 70, 80, 90) représente des points d'objet sur l'élément optique réfléchissant (10) sur respectivement un pixel sur un détecteur (20), **caractérisé en ce qu'**un arrangement de mesure selon l'une quelconque des revendications 1 à 11 est utilisé à cet effet.

15. Procédé selon la revendication 14, **caractérisé en ce que** la représentation des points d'objet sur l'élément optique réfléchissant (10) sur respectivement un pixel sur un détecteur (20) est effectuée dans une pluralité d'étapes partielles qui sont différentes en ce qui concerne la longueur d'onde de travail lors de cette représentation.
